# EUROPEAN PATENT APPLICATION

(11) **EP 2 031 716 A2**
(43) Date of publication of application: **04.03.2009**
(21) Application number: 08019495.4
(22) Date of filing: 15.04.2005
(51) Int. Cl.: H01S 5/0625, H01S 5/068, H01S 5/0687

(54) **Wavelength control of laser light**

(30) Priority: 15.04.2004 GB 0408415
(62) Divisional of application: 05734563.9
(71) Applicant: Cambridge Enterprise Limited, Trinity Lane Cambridge Cambridgeshire CB2 1TN (GB)
(72) Inventor: Davies, Andrew R., Coventry CV5 7HG (GB); Bennett, Peter Jonathan, Chelmsford, Essex CM1 4UG (GB); Penty, Richard V., Cambridge CB3 0FD (GB); White, Ian Hugh, Cambridge CB2 1PZ (GB)
(74) Representative: Neobard, William John

(57) **Abstract**

A wavelength control system (1) comprising: a wavelength tunable laser (2) comprising plural sections defining together a waveguide, at least one of the sections being a phase shifter section (7), and at least one of the sections being a gain section (8); the wavelength control system further comprising a temperature sensing mechanism (4) and a bias controller (3); the bias controller arranged to control a bias of at least one of the sections, wherein substantially constant wavelength operation is achieved by controlling the bias, the bias varying with the sensed temperature; and wherein the phase shifter section is sufficiently longer than the gain section to allow mode-hop free operation of the wavelength tunable laser while maintaining substantially constant wavelength operation.

## Description

### Field of the invention

This invention relates to a wavelength control system, to a method of operating a laser diode, to an uncooled laser diode, to a device for emitting modulated light and to a WDM system. Embodiments of the invention are also useable outside the communications sphere.

### Background of the invention

Due to the current economic climate, low cost solutions such as uncooled transmitters, are key components for Coarse Wavelength Division Multiplexed (CWDM) systems see, M. Silver et al, IEEE Photonics Technology Letters, 14 (2002), pp741-743. Current specifications for such systems are usually for wavelength channel spacing of approximately 20nm, see L. Buckman et al, IEEE Photonics Technology Letters, 14 (2002), pp702-704. The wide channel spacing is necessary due to the temperature dependence of the operating wavelength of DFB lasers. Typically the wavelength drift of such sources is at a rate of 0.1nm per °C, i.e. 10 nm over an entire desired operation range of∼100 deg C.

The prior art wavelength stabilisation techniques in WDM systems suffer from relying upon expensive coolers, which are bulky and have high power consumption, see L. Colace et al, Applied Physics Letters, 80(17) (2002), pp3039-3041.

An aim of embodiments of the present invention is to reduce the channel spacing of uncooled WDM systems, allowing more channels to be used, or indeed allow increased numbers of uncooled channels to use less bandwidth, enabling the use of amplifiers in uncooled WDM systems.

An additional aim of embodiments of the present invention is to provide substantially constant wavelength operation of uncooled lasers in measurement and sensing systems.

Some embodiments of the invention avoid the use of wavelength lockers. Such embodiments can result in WDM devices and systems of even lower cost

### Summary of the invention

According to a first aspect of the present invention there is provided a wavelength control system comprising a wavelength tunable laser, a temperature sensing mechanism and a bias controller responsive to the sensed temperature whereby emission wavelength of the wavelength tunable laser is maintained substantially constant by adjusting the bias applied to the wavelength tunable laser accordingly with temperature.

The bias controller may be operable to provide controllable injection current that is varied with said temperature.

The wavelength tunable laser may comprise a diode, and the bias controller be operable to provide controllable reverse voltage across the diode, said voltage varying with said temperature.

The wavelength tunable laser may comprise plural portions, also referred to herein as "sections", defining together a waveguide, at least one of the sections being a frequency tuning section, wherein the bias controller is operable to provide controllable injection current to the frequency tuning section, the current varying with said temperature.

The wavelength tunable laser may comprise plural sections defining together a waveguide, at least one of the sections being a tuning section, wherein the bias controller is operable to provide a controllable reverse bias voltage across the frequency tuning section, the voltage varying with said temperature.

At least one of the sections may be a phase control section and the system may further comprise a controller for varying a bias applied to the phase control section for preventing mode-hopping.

The wavelength control system may comprise means for maintaining the emission of the wavelength tunable laser substantially mode-hop free.

The wavelength control system may further comprise a wavelength selection means, and wherein the wavelength tunable laser comprises at least a first semiconductor gain portion, and at least a first passive phase shifter portion, wherein the length of the phase shifter portion is greater than the length of the gain portion.

The wavelength tunable laser may comprise a wavelength selective portion which forms said wavelength selection means, and said wavelength selective portion reflect light of at least certain wavelengths.

The wavelength selective portion may comprise a grating portion.

The laser may have front and rear facets and further comprise a feedback mechanism and a means for sensing the power output from the front and rear facets of the wavelength tunable laser.

According to a second aspect of the invention there is provided a method of operating a laser diode, the laser diode having at least a first wavelength selective reflector, at least a phase control section and first and second substantially opposing facets through which in use laser light is emitted, the method comprising sensing the output powers of laser light from the two facets, while varying control of the laser diode in response to temperature variations so as to maintain a constant wavelength of the light output, and controlling bias of the phase control section to reduce variations in a ratio of output powers from the two facets.

According to a third aspect of the invention there is provided a laser diode operating device for a laser diode having at least a first wavelength selective reflector, at least a phase control section and first and second substantially opposing facets through which in use laser light is emitted, the operating device comprising: wavelength control means for varying control of the laser diode in response to temperature variations so as to maintain a constant wavelength of the light output; power sensing means for sensing the output powers of laser light from the two facets, and bias control means for controlling bias to the phase control section such as to reduce variations in a ratio of output powers from the two facets.
The wavelength control means may comprise a device for providing a controlled current to a gain portion of the laser diode.

According to a further aspect of the present invention there is provided an uncooled semiconductor laser diode comprising plural portions cooperating to define a waveguide, and control circuitry for varying the refractive index of at least part of the waveguide and arranged to cause substantially mode-hop free single-mode laser oscillation in said uncooled semiconductor laser diode.

According to a yet further aspect of the present invention there is provided a method of operating an uncooled semiconductor laser diode, said uncooled semiconductor laser diode comprising: at least a first semiconductor gain portion, a tunable phase shifter means and at least a first wavelength selector, said method comprising the steps of: supplying a current to said semiconductor gain portion, said current being above a threshold value thereby to cause laser oscillation in said uncooled semiconductor laser diode, and a tuning step wherein an emission wavelength, a roundtrip phase and a round trip gain are independently tuned accordingly with temperature of said uncooled semiconductor laser diode, thereby maintaining a substantially constant emission wavelength over an expected operating temperature regime.

The first wavelength selector may comprise a grating portion, and said step of tuning comprises varying the current supplied to said grating portion. The tunable phase shifter means may comprise a phase shifter portion of the diode, said portion being disposed between said semiconductor gain portion and said grating portion, said method further comprising the step of adjusting the current supplied to said semiconductor phase shifter. The first grating may be a sampled grating, a chirped grating, or a section of uniform grating.

Control of the refractive index of the waveguide sections may be caused by one or more of the group comprising the free carrier plasma effect, the electro-optic effect, the Franz-Keldysh effect or the quantum confined Stark effect.

In a still further aspect the invention provides a device for emitting modulated light comprising a wavelength control system according to the first aspect, or an uncooled semiconductor laser diode according to the further aspect.

The invention also relates to a WDM system comprising a plurality of devices according to the still further aspect.

### Diode temperature may be sensed, or may instead be predicted or implied

Some embodiments of the invention may be fully retroactive, and provide closed loop feedback to ensure output control. Others however may use open loop control, for example by virtue of pre-calibrated devices and look-up tables to allow control parameters to be derived.

The invention also relates to a laser diode in accordance with an earlier aspect of the invention together with a separate modulator. Such a modulator could be integrated on a common substrate with a diode embodying the invention, or could be a modulator truly discrete from such a diode.

The invention further envisages a semiconductor-optical amplifier (SOA) disposed to receive light from a laser diode embodying the invention.

Embodiments of the present invention provide an uncooled optical transmitter, which can operate at substantially constant emission wavelength over a wide temperature range. Non-communication embodiments are also envisaged.

### Brief description of the drawings

The invention will now be described, by way of example, with reference to the accompanying drawings, in which:
Figure 1 is a schematic diagram of the wavelength control system, having a semiconductor laser diode controlled to emit light of substantially constant wavelength;
Figure 2 is a graph of grating current as a function of the semiconductor laser diode temperature;
Figure 3 is a graph of the emission wavelength from said semiconductor laser diode as a function of temperature, when only the grating current is adjusted, also shown is a plot of emission wavelength from the semiconductor laser diode when no control mechanism is employed;
Figure 4 shows a series of constant wavelength contours over temperature as a function of the current injected into a phase shifter portion and a grating portion of a laser diode;
Figure 5 (a) is a plot of CW operation of a laser diode, showing peak wavelength variation with temperature without control, with grating-section control only embodying the invention, and with both grating and phase-section control embodying the invention; Figure 5(b) shows a detailed view of the variations under the two control regimes;
Figure 6 is a plot of optical power output from front and back facets of a semiconductor laser diode as a function of gain portion current;
Figure 7 shows the emission wavelength of a simulated semiconductor laser diode;
Figure 8 is a plot of simulated emission wavelength of a semiconductor laser diode as a function of temperature using a current control system;
Figure 9 shows how mode-hopping may be suppressed by embodiments of the invention;
Figure 10 shows the dynamic side mode suppression ratio of a laser embodying the invention under 3.125Gb/s direct modulation;
Figure 11 shows the spectrum of a laser embodying the invention under 3.125 Gb/s direct modulation;
Figure 12 shows unfiltered eye diagrams of a laser embodying the invention under 3.125Gb/s direct modulation at (a) 10°C, (b) 30°C, (c) 50°C and (d) 70°C, with a time base of 80 ps/div.

### Description of the preferred embodiments

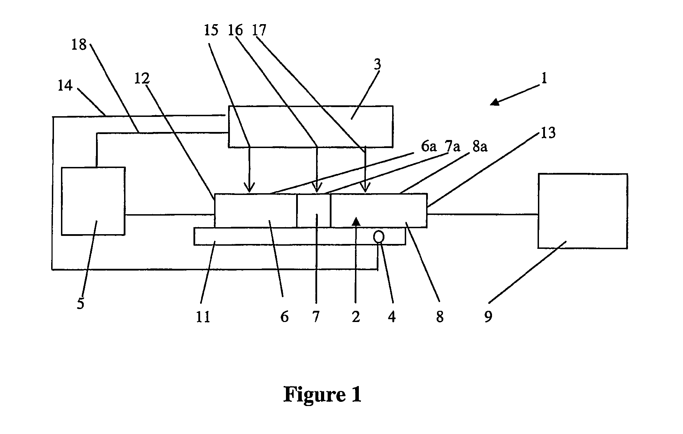

Referring to Figure 1, a wavelength control system 1 has a semiconductor laser diode 2, a bias controller 3, an optical power meter 5 and an optical spectrum analyser 9. The laser diode has three contacts providing connections to an electrically tunable grating portion 6, an electrically tunable phase shifter portion 7 and a semiconductor gain portion 8. The grating portion 6, phase shifter portion 7 and gain portion 8 are contiguous and thereby define a waveguide, having a back facet 12 and a front facet 13. The laser diode 2 is disposed on a substrate 11 which provides an electrically-common substrate connection. The electrically tunable grating portion 6 defines the back facet 12. In this embodiment of the invention laser diode 2 has the phase shifter portion 7 disposed between the grating portion 6 and the gain portion 8, and the gain portion 8 defines the front facet 13. In a first variant, the effective phase shift provided by the phase shifter portion 7 is relatively long - for example a physical length substantially greater than that of the gain portion 8 may be provided. In another variant the achievable phase shift is increased by semiconductor technology, for example by quantum well intermixing techniques, allowing the phase shifter portion to remain relatively short. The invention is not however restricted to any particular length of phase shifter, and embodiments may use small phase shifter lengths in appropriate circumstances. The bias controller is, in this embodiment, a current controller 3, that is connected to supply currents from outputs 15,16,17 to respective electrodes 6a, 7a and 8a of the respective portions of the laser diode 2. The optical power meter 5 is disposed to monitor the power output at the back facet 12 and to provide feedback 18 to the current controller 3. A closely placed temperature-sensing element 4 is provided to measure the temperature of the laser diode 2 and has an output connected to provide feedback 14 to the current controller 3. The temperature-sensing element 4 in this embodiment of the invention is a thermistor, however it is envisaged that a thermocouple or other means known in the art could be used. The optical spectrum analyser 9 is disposed to monitor the output wavelength, optical power and Side Mode Suppression Ratio of the light emitted from the front facet 13 of the laser diode 2. In this embodiment, the front facet 13 is slightly mirrored to provide a cavity between the grating portion 6 and the front facet 13. However the invention is also applicable to other types of laser where reflection is not provided. In this embodiment the laser diode is uncooled.

In this embodiment of the invention, the grating portion is a continuous grating portion 6. In other embodiments it is envisaged that the grating portion may be a chirped or sampled grating or alternatively a combination of continuous, chirped or sampled gratings.

The grating portion in this embodiment acts as a reflector of light having a wavelength substantially that of the Bragg wavelength, as will be apparent to one skilled in the art. Thus it forms a frequency selective element and at the same time a reflector element.

The wavelength control system 1 employs the current outputs 15,16,17 to operate and control the laser diode 2. In this embodiment of the invention laser oscillation is achieved by biasing the gain portion 8 above a threshold value. Substantially constant wavelength operation can be achieved by controlling the current outputs 15,16,17 which are applied to the grating portion 6, phase shifting portion 7 and gain portion 8. In the described embodiment, the grating portion 6 is tunable by the free carrier plasma effect. Increasing the current bias to the grating portion causes an increase in the carrier density. This changes the effective refractive index of the waveguide in the grating section and hence changes the Bragg wavelength.

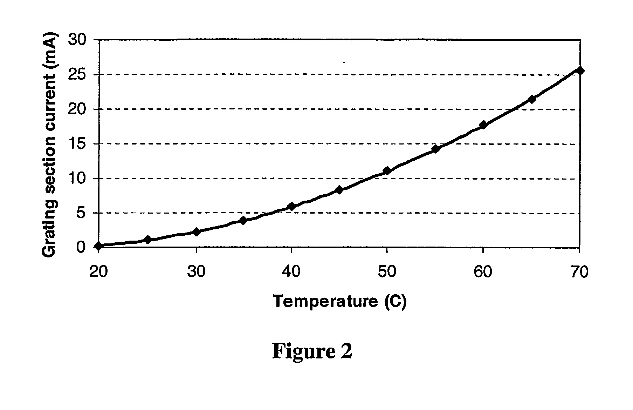

Figure 2 shows how the current output 15 applied to the grating portion 6 can be used to control the emission wavelength of the laser diode 2 with temperature. A curve fitted to the data of Figure 2 can be used to calculate the current output 15 applied to the grating portion 6 which is required to achieve a specific emission wavelength over an operating temperature range of 20-70°C. A series of such contours enables the generation of control algorithms to achieve various specific emission wavelengths.

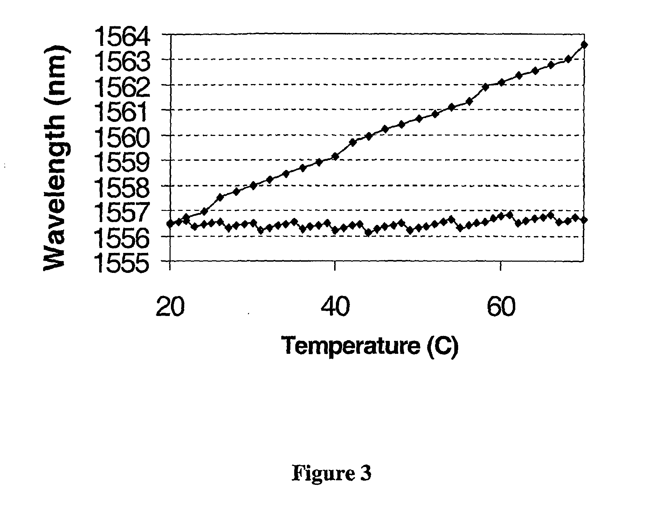

Figure 3 shows the emission wavelength of laser diode 2 with increasing temperature, when the laser diode 2 is controlled using the algorithm generated from Figure 2 and implemented by feedback 14. It will be seen that in the embodiment the controlled wavelength is constant to within ±0.3nm. Also shown is the emission wavelength of laser diode 2 when the current supplied to the grating portion 6 is not controlled.

In a second embodiment, instead of a current controller 13, there is provided a voltage controller responsive to diode temperature for controlling the reverse-bias to the diode and hence the electric field in the diode 2. In both the first and second embodiments, the effect of varying current or voltage is to change the refractive index of one or more portions of the diode. It is of course possible to vary both voltage and current.

Throughout the rest of this document, reference is made to current control of a laser diode. It is to be understood that unless the context indicates otherwise, voltage control is also and alternatively possible, although for brevity is not specified.

An additional feature of the first and second embodiments of the present invention is that the optical mode within the laser diode 2 can be further controlled. By controlling the current output 16, which is applied to the phase shifter portion 7, the emission wavelength of the main optical mode, which oscillates within the laser diode 2, can be 'fine tuned'. A similar method as described above can be used to determine the value of the current output 16, which is required to select a particular oscillating mode at a specific wavelength.

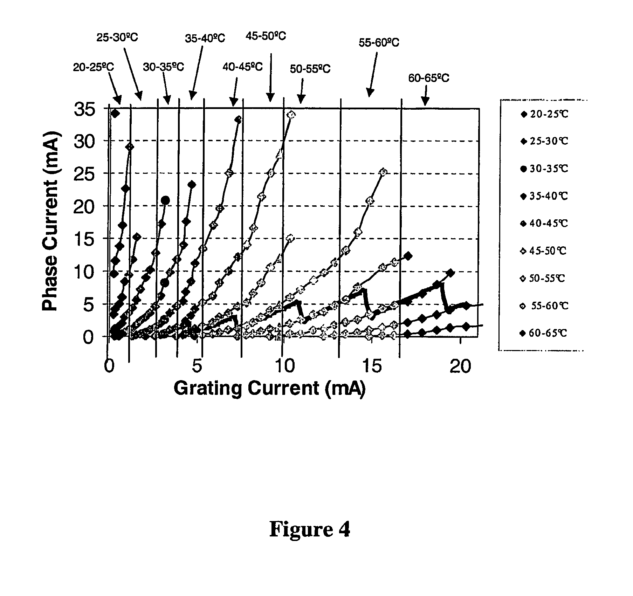

Figure 4 shows an example map of the required current applied to the phase portion 7 and to the grating portion 6 to control the emission of laser diode 2. This is generated by fixing the bias, e.g. current, applied to the grating portion 6 according to Figure 2 and sweeping the current applied to the phase portion 7. In this way the values of both currents which are required to achieve a specific emission wavelength can be determined for the operating temperature range.

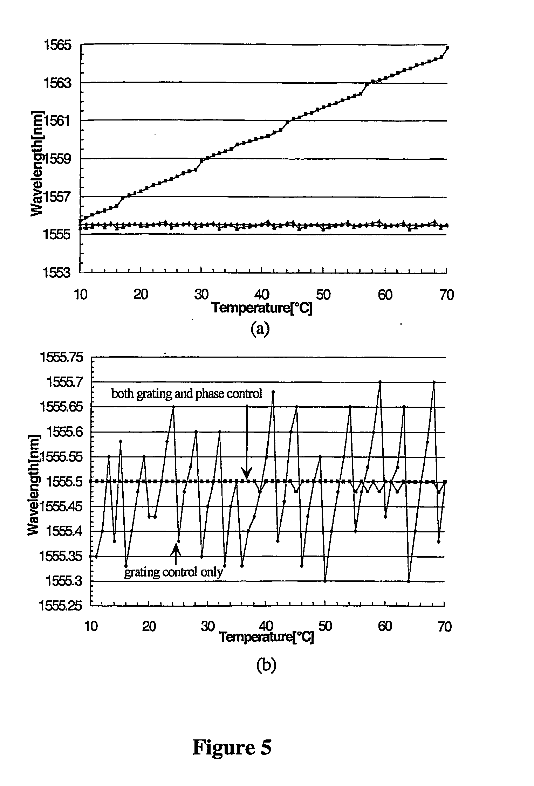

Referring to Figure 5(a) the plot using squares is of the uncontrolled wavelength variation which rises steadily with temperature. By contrast the control using grating-section control (triangles) is much more constant but with some variations (better seen in Figure 5(b)), whereas the result of control using both grating and phase sections is substantially a constant wavelength (again best seen in Figure 5(b)).Varying the bias of the gain portion, e.g. increasing current injected into the gain portion 8 can cause changes to the refractive index in the gain portion 8, and therefore the roundtrip phase. This can cause the optical output of the laser diode 2 to mode-hop.

A further feature of this embodiment of the invention is a means for controlling mode-hopping. It is noted that when approaching a mode-hop, either as a result of temperature changes of the diode or due to changes in bias to take into account the temperature change and eliminate its effect on wavelength, the ratio of the optical power output from the back facet 12 to the optical power output from the front facet 13 increases.

Other techniques for predicting mode-hopping may alternatively be used, such as detection of forward voltages, for example.

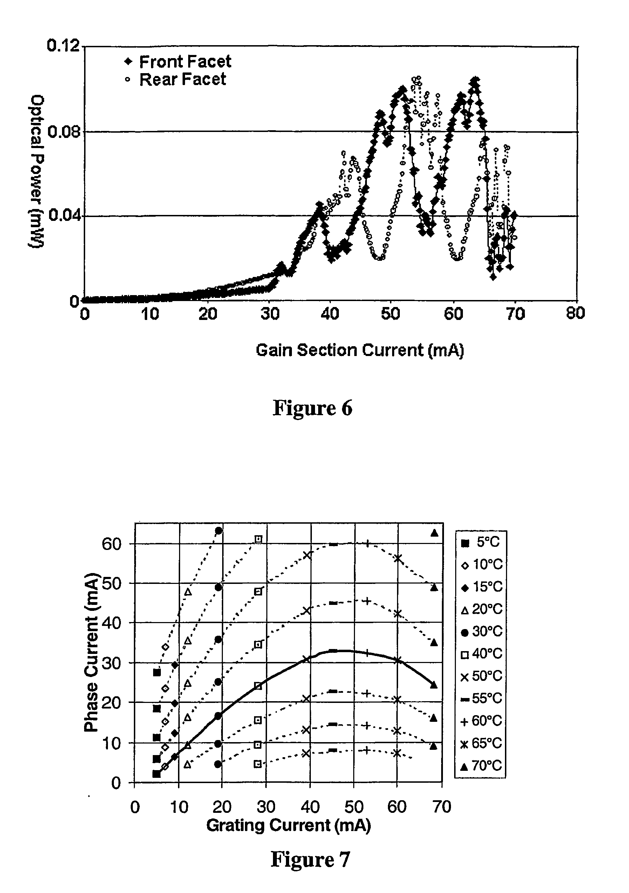

Figure 6 shows, for a laser diode having a passive grating portion 6 and a semiconductor gain portion 8, the output powers from the two facets 12,13 of the laser plotted against current injected into the gain portion. This can be employed as a further feedback mechanism 18 which can compensate for changes in phase due to temperature. Maintaining the ratio of output powers from the two facets results in mode-hop free operation. In this case changing the current injected into the gain portion 8 compensates for the change in roundtrip phase caused by a change of temperature. The ratio of output powers from the two facets is maintained. In this embodiment, an external amplifier can be used to maintain the overall output power.

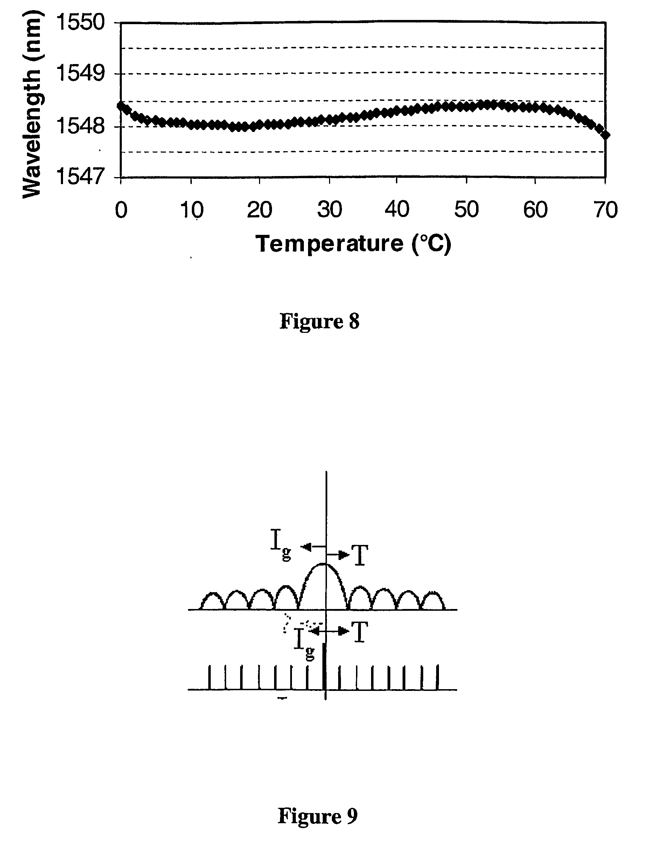

It is envisaged that other means for controlling mode-hopping can be employed. In a second embodiment of the present invention for example a greater degree of phase shifting is required to avoid mode-hops. A laser model has shown that an increased ratio of the length of the phase shifter portion 7 to the length of the gain portion 8, compared with that used in experimental demonstration would allow substantially constant wavelength emission, which is substantially mode-hop free. This is achieved by adjusting the current supplied to the grating portion 6 and phase shifter portion 7 without the need to employ feedback 18. It is envisaged that in other embodiments both the increased phase portion 7 to gain portion 8 length ratio and feedback 18 could be employed simultaneously. Figure 7 shows a series of constant wavelength contours as a function of grating current and phase current for a wavelength tunable laser having, in this second embodiment a phase portion 7 that is twice the length of the gain portion 8. It should be noted that the current supplied to the grating portion 6 is a function of temperature, similar to that indicated by Figure 2. The wavelength is seen to be constant along continuous contours in Figure 7, and the emission wavelength achieved by operating along the solid contour in Figure 7 is shown more clearly by Figure 8, which is a graph of wavelength as a function of temperature indicating mode-hop free emission at a substantially constant wavelength, when the current control is set according to Figure 7.

Thus an embodiment of the present invention provides an uncooled optical transmitter, which can operate at substantially constant emission wavelength over a wide temperature range. Its use can enable the reduction of channel spacing in WDM systems, allowing more channels to be used, or indeed allowing increased numbers of uncooled channels to use less bandwidth, enabling the use of amplifiers in uncooled WDM systems. This is because mode-hopping can be prevented while providing frequency stabilisation with temperature change. In such an optical transmitter the power output from the back facet might for example be a photodiode disposed on the submount 11. Once a diode has been characterised look-up tables may be used in cooperation with a microprocessor controller for varying the currents to be injected, or respectively voltage to be applied. In other embodiments, the microprocessor may be eliminated where a laser diode is capable of a large phase change. In this case the currents supplied to the grating and phase section are at least substantially directly proportional to one another, and direct feedback from the temperature sensing element may thus result in a constant wavelength output.

In the embodiments described above, a single device, the grating performs both wavelength selection and reflection. However other embodiments are envisaged in which separate devices perform these functions individually. In one example a broadband reflector is provided and a tunable filter in the cavity. In another example, a configuration is used to split out the different wavelengths and then only reflects the desired ones. This may be performed by an optical frequency demultiplexer in which different wavelengths are deviated from a path by different angles and only those at certain angles are returned. Another configuration is an AWG with a variable reflector on the end.

Referring to Figure 9, the effect of control using embodiments of the invention is illustrated. The top curve shows the effect of temperature tending to "pull" the peak wavelength of the DBR filter to the right - i.e. towards higher frequencies but this is opposed and substantially neutralised by control of the grating section current "pulling" the DBR characteristic back to its desired value.

The second plot shows the longitudinal modes, which are also affected by temperature and will drift even with the grating section control. To prevent mode-hops, the mode is to be maintained aligned with the DBR filter, and this can be achieved by the additional constraint provided by the control of the phase section.

Diodes embodying the invention may be directly modulated, giving the advantage of avoiding the need for expensive and bulky external modulators. In an experimental set-up an uncooled DBR laser for assessment as an athermal WDM transmitter was directly modulated at a data rate of 3.125Gb/s.

To achieve this, a peak-to-peak voltage swing between 1V and 2V was superimposed on the voltage bias to the gain section to achieve direct modulation. A 2⁷-1 pseudo random binary sequence (PRBS) pattern generator at 3.125Gb/s was employed as the data source, in order to represent similar transition density to common data communications standards such as Gigabit Ethernet.

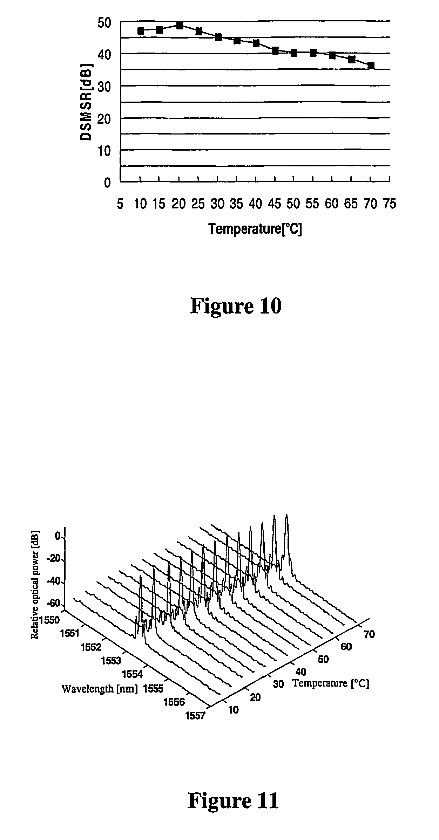

Referring to Figures 10 and 11 satisfactory single mode operation was constantly maintained from 10°C to 70°C. Figure10 demonstrates dynamic side mode suppression ratio (DSMSR) consistently higher than 35dB, although with a decreasing trend against increased temperature, as expected. Figure 11 shows typical spectra under modulation as a function of temperature. Stable single-mode operation is always maintained. The peak wavelength has a variation of ±0.2nm, centered on 1557.43nm, over a temperature span of 20°C to 70°C.

It is noted that in the modulation experiments, the gain section bias was not maintained at a constant value. It was varied to compensate for the loss of output power due to temperature rise, as well as to maintain optimum DC bias point so that good open eye diagrams at individual temperature points can be obtained. However, with such bias adjustment, the laser wavelength exhibited further variation, mainly due to carder-heating effect. If excessive grating current were applied to bring the peak wavelength back, the laser might stop lasing due to the extra loss induced by carrier injection into the passive grating section. Therefore the modulation itself basically explains the slightly larger wavelength deviation of ±0.2nm, compared with that of CW operation, yet this still indicates more than an order of magnitude reduction relative to the 20nm channel spacing specified by conventional CWDM systems.

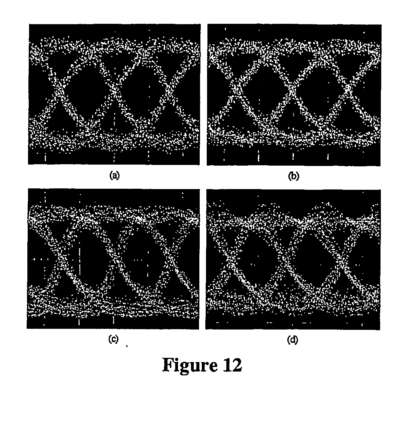

Successful direct modulation results with open unfiltered eye diagrams were consistently obtained with a high bandwidth oscilloscope optical plug-in, of which 10°C, 30°C, 50°C and 70°C results are displayed in Fig. 12. There is thus good potential for link operation. The eyes maintain good damping behavior until high temperatures, where slightly more overshoot and increased patterning in the zero level may be observed, limited by the bandwidth degradation due to the temperature rise.

Diode temperature may be sensed in a number of ways, and indeed in embodiments, sensing may be an inappropriate term. For example it may be possible rather than sensing the temperature to instead predict it, or to use a pre-existing model that allows temperature to be estimated on the basis of other parameters that are measured. Where a sensor is provided it may be a discrete sensor, or instead sensing may rely upon parameters being measured and used to imply temperature.

Some embodiments of the invention may be fully retroactive, and provide closed loop feedback to ensure output control. Others however may use open loop control, for example by virtue of pre-calibrated devices and look-up tables to allow control parameters to be derived.

Although the device has been described in terms of communications, it is envisaged that it would be useful for non-communications applications. In some such applications, mode-hopping may not be as significant as it may be in some communications applications.

Although an embodiment has been described that uses direct modulation, it is of course envisaged that a separate modulator could be used, for example for high data rates. Such a modulator could be integrated on a common substrate with a diode embodying the invention, or could be a modulator truly discrete from such a diode.

In another application a semiconductor-optical amplifier (SOA) is disposed to receive light from a laser diode embodying the invention. Control of the SOA is then carried out to cope with inherent power variations caused by control of the laser diode, the laser diode being controlled so as to avoid mode-hops.

Embodiments of the invention have now been described. It will be understood however that the invention is not restricted to the described features but instead extends to the full extent of the appended claims.

## Claims

1. A wavelength control system comprising:
a wavelength tunable laser comprising plural sections defining together a waveguide, at least one of the sections being a phase shifter section, and at least one of the sections being a gain section;
a temperature sensing mechanism; and
a bias controller arranged to control a bias of at least one of the sections,
wherein substantially constant wavelength operation is achieved by controlling the bias, the bias varying with the sensed temperature;
wherein the phase shifter section is sufficiently longer than the gain section to allow mode-hop free operation of the wavelength tunable laser while maintaining substantially constant wavelength operation.

2. A wavelength control system according to claim 1, wherein the bias controller uses at least one look-up table having stored constant wavelength contours to determine the bias.

3. A wavelength control system according to claim 1 or 2, wherein the phase shifter section is twice the length of the gain section.

4. A wavelength control system according to any preceding claim, wherein at least one of the sections is a wavelength selective section.

5. A wavelength control system according to claim 4, wherein the wavelength tunable laser is capable of a sufficiently large phase change that a bias supplied by the bias controller to the wavelength selective section and a bias supplied by the bias controller to the phase shifter section are substantially directly proportional to each other, and wherein the emission wavelength is maintained substantially constant by direct feedback from the temperature sensing mechanism.

6. A method of avoiding mode hopping in a wavelength control system, the wavelength control system comprising a wavelength tunable laser, wherein the wavelength tunable laser has a waveguide comprising at least a phase shifter section, and a gain section, the method comprising:
sensing a temperature of the wavelength control system;
supplying a bias to at least one of the sections, wherein substantially constant wavelength operation is achieved by controlling the bias, the bias varying with the sensed temperature;
wherein the phase shifter section is sufficiently longer than the gain section to allow mode-hop free operation of the wavelength tunable laser while maintaining substantially constant wavelength operation.

7. A method according to claim 6, further comprising using at least one look-up table having stored constant wavelength contours to determine the bias.

8. A method according to claim 6 or 7, wherein the phase shifter section is twice the length of the gain section.

9. A method according to claim 6, 7 or 8, wherein the waveguide of the wavelength tunable laser further comprises a wavelength selective section.

10. A method according to claim 9, wherein the wavelength tunable laser is capable of a sufficiently large phase change that a bias supplied by the bias controller to the wavelength selective section and a bias supplied by the bias controller to the phase shifter section are substantially directly proportional to each other, and wherein the emission wavelength is maintained substantially constant by direct feedback from the temperature sensing mechanism.
